# EUROPEAN PATENT SPECIFICATION

(11) **EP 1 455 408 B1**
(45) Date of publication and mention of the grant of the patent: **21.06.2006**
(21) Application number: 04290604.0
(22) Date of filing: 05.03.2004
(51) Int. Cl.: H01M 8/10, H01M 4/88

(54) **Method for preparing membrane electrode assemblies**
Verfahren zur Herstellung einer Elektrodenmembrananordnung (MEA)
Procédé pour la production d'un ensemble électrode-membrane (MEA)

(30) Priority: 06.03.2003 US 452324 P; 06.02.2004 US 773822
(43) Date of publication of application: 08.09.2004
(73) Proprietor: Arkema Inc., Philadelphia, PA 19103-3222 (US)
(72) Inventor: Culp, Thomas Dudley, Drexel Hill, Pennsylvania 19026 (US); Hedhli, Lotfi, Ardmore, Pennsylvania 19003 (US); Silverman, Gary Stephen, Chadds Ford, Pennsylvania 19317 (US); Tro Adjemian, Kevork, King of Prussia, Pennsylvania 19406 (US)
(74) Representative: Treuil, Claude

(56) References cited:
- US-A- 5 750 013
- US-A1- 2002 058 143
- US-B1- 6 403 245

## Description

### Technical Field

This invention relates to a method for preparing membrane electrode assemblies (MEAs), and in particular to a method of manufacturing a proton-conducting cation-exchange electrolyte membrane for use in a membrane electrode assembly (MEA), in which atmospheric pressure plasma deposition is used to deposit catalysts such as platinum onto a polymer substrate, or a substrate including carbon cloth or carbon particles.

More specifically, the invention has two principal characteristics:
- the noble metal catalyst is deposited on the membrane by electrical discharge enhanced chemical vapor deposition (DECVD); and
- the DECVD is carried out at atmospheric pressure, without adding noble gases to the DECVD carrier gas.

### Background Art

MEAs are used in proton exchange membrane fuel cells (PEMFCs), and direct methanol fuel cells (DMFCs). They typically include a selectively permeable polymer electrolyte membrane bonded between an anode electrode and a cathode electrode, one or both of which contains a catalyst. The catalyst is usually a noble metal such as platinum.

The most common conventional MEA fabrication technique is to use carbon supported platinum electrodes consisting of a porous carbon cloth material with platinum particles deposited on the active side of the cloth material.

This method is used, for example, to make ELAT electrodes sold by E-Tek Inc. To aid in the proton conductivity of the electrodes, Nafion® is applied to the active area, and the electrodes are then sandwiched onto the membrane by hot-pressing.

The conventional MEA fabrication technique has a number of disadvantages:
- Membrane catalyst loadings in MEAs made by the conventional method are high, typically in the range of 0.4 to 2.0 mg/cm².
- Pure platinum suffers from carbon monoxide poisoning, which is especially relevant when the fuel cell is running on reformed fuels.
- When the fuel cell is running on methanol, poor methanol activity at the anode significantly reduces its efficiency.
- Low oxygen reduction activity at the cathode also plays a significant role in reducing the overall efficiency of the fuel cell, particularly when air is used as the oxidizing gas.
- The overall process to prepare these types of MEAs is costly, time consuming, and complex, with many areas of concern for quality.

A recent alternative to the conventional MEA fabrication technique involves vacuum sputtering the platinum directly onto the membrane, and then hot-pressing carbon cloth on the active layer. Examples are disclosed in US 6,303,244; US 6,171,721; US 6,425,993; U.S. 2002004453; A. Huag *et al.,* "Increasing Proton Exchange Membrane Fuel Cell Catalyst Effectiveness Through Sputter Deposition," *Journal of the Electrochemical Society,* vol. 19, pp. A280-A287 (2002), and R. O'Hayre *et al.,* "A Sharp Peak In Performance Of Sputtered Platinum Fuel Cells At Ultra-Low Loading," *Joumal of Power Sources*, vol. 109, pp. 483-494 (2002).

Vacuum sputtering has the disadvantage that the process has to be done under vacuum, requiring potentially expensive vacuum chambers and pump systems. In addition, the resulting membrane suffers from the disadvantages of pure platinum noted above, including carbon monoxide poisoning. While simpler than using carbon supported platinum electrodes, the overall MEA fabrication process is still costly, time consuming, and complex.

Another possibility is to use chemical vapor deposition, and in particular plasma enhanced chemical vapor deposition (PECVD), to deposit metals on polymer membranes, carbon cloth, or carbon particles. PECVD is preferable to traditional CVD because, in traditional CVD, appreciable growth rates are attainable only at relatively high substrate temperatures (typically 500-1,200 °C), which would damage the polymer membrane on which the metal is to be deposited, whereas PECVD is commonly performed at substrate temperatures from room temperature to 200 °C. However, conventional PECVD is typically performed in vacuum systems at pressures ranging from a few hundred µ Torr to a few Torr (a few dozen Pa to a few hundred Pa). As a result, PECVD suffers from the same process disadvantages as vacuum sputtering, in that the use of vacuum chambers and pumping systems greatly increases the expense, as well as the difficulty in scale-up for large volume manufacturing.

One way to avoid the need for a vacuum system is to use atmospheric pressure plasma techniques such as DECVD that rely on passage of the reactants through an electrical discharge. In particular, DECVD techniques are preferred in which the discharge occurs between electrodes positioned above the substrate rather than when the substrate is located between the electrodes and the discharge occurs to the substrate itself. Placement of the substrate between the electrodes, as disclosed for example in Thyen *et al., Surface Coating Technology,* vol. 97, p. 426 (1997), is less suitable in MEA manufacture because of difficulties in manipulating the substrate during discharge, and potential interference by the substrate with the discharge.

Atmospheric pressure plasma deposition techniques in which the reactants are passed through the discharge before they reach the substrate offers the advantages of low temperature and atmospheric pressure processing. However, the cost of these techniques can still be high due to the use of noble gases, such as He and Ne, to prevent microarcing and to stabilize the plasma discharge. Examples of atmospheric pressure discharge techniques utilizing electrode-to-electrode discharge in the presence of noble gases are disclosed in US 6,194,036; US 6,262,523; US 5,198,724; US 5,549,780; US 6,013,153; and US 5,185,153; WO 99/42636 and WO 00/70117; and Ha *et al., Applied Physics Letters*, vol. 64, p. 46 (1994).

In general, prior art plasma or discharge deposition methods have required either that processing be carried out in a vacuum, and/or that noble gases be used as a stabilizer. For example, WO 00/70117, page 24, lines 11-20 draws a distinction between plasma discharge processes carried out at pressures below 100 Torr 13.3 kPa, which do not benefit from the presence of noble gases, and processes carried out at pressures above 100 Torr 13.3 kPa (atmospheric pressure being defined as 760 Torr 101.325 kPa, in which noble gases provide a stabilizing effect. Like the other references cited above, WO 00/70117 does not disclose or suggest use of DECVD to deposit catalysts on MEA membranes, and in particular does not address the high cost of vacuum processing or noble gases, either of which makes conventional discharge deposition methods of the type disclosed in WO/70117 impractical for use in MEA manufacture.

### Disclosure of invention

It is accordingly an objective of the invention to provide a method of fabricating MEAs that can be carried out at low temperatures so as to enable a wide variety of polymers and catalysts to be used as materials for the MEA substrate, and yet that is relatively low in cost.

This objective is accomplished, in accordance with the principles of various preferred embodiments of the invention, by the method of claim 1, in which DECVD is used to deposit catalysts such as platinum directly onto the surface of a suitable substrate, such as a proton-conducting polymer membrane. This technique can also be used to deposit metals onto a carbon cloth or a membrane including carbon particles. Contrary to the prior teachings discussed above, the DECVD method used by the preferred embodiments of the invention is carried out at atmospheric pressure without use of noble gases to prevent arcing and stabilize the plasma, thereby substantially reducing manufacturing costs.

The catalyst for the MEA membrane is thus deposited onto the membrane by means of an atmospheric pressure technique in which vaporized reactants are transported to a substrate on which surface reactions occur, and subjected to an arc discharge as they pass to the substrate. In a manner similar to low pressure PECVD, the concept is to use energetic electrons to excite the gas phase reactants electrically rather than thermally, thus obtaining high deposition reaction rates while at a lower substrate temperature. Because the process can be done in an open system, the expense of vacuum systems is avoided and scale-up for large industrial processes is much simpler.

Vaporized reactants and carrier gas passing through the discharges to the substrate form activated species which react on the substrate surface to deposit the desired material at low substrate temperature, allowing treatment of low melting materials such as polymer membranes. As a result, the method of the invention can use a variety of DECVD apparatus configurations, including those with parallel or coaxial electrodes, thereby providing maximum flexibility in implementation. Also, the use of low temperature DECVD to deposit catalysts on the MEA membrane enables the use of commercial polymeric membrane materials such as Nafion® and Aciplex®, as well as other heat-sensitive proton conducting membrane materials such as the acrylic based electrolyte/fluoropolymer blend disclosed in WO 0160872, and a variety of catalyst materials other than the conventional pure platinum.

In the case of platinum or a platinum alloy as the catalyst, additional advantages of using DECVD to apply the catalyst directly on the polymeric membrane include:
- improved efficiency of the platinum catalyst
- reduced catalyst loading and associated cost
- the elimination of additional polyelectrolytes on the electrode, and their associated cost
- a greatly simplified MEA fabrication process with fewer steps
- work at relatively low temperatures.

### Brief description of Drawings

Fig. 1 A is a schematic view of a linear slit-type nozzle apparatus that may be used to implement the principles of the invention.

Fig. 1B is a schematic view of a concentric cylindrical-type nozzle apparatus that may also be used to implement the principles of the invention.

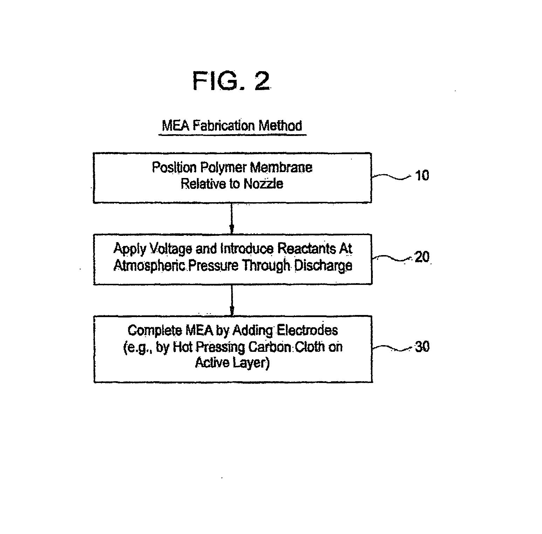

Fig. 2 is a flowchart illustrating the MEA fabrication method of a preferred embodiment of the invention.

### Best modes for carrying out the invention

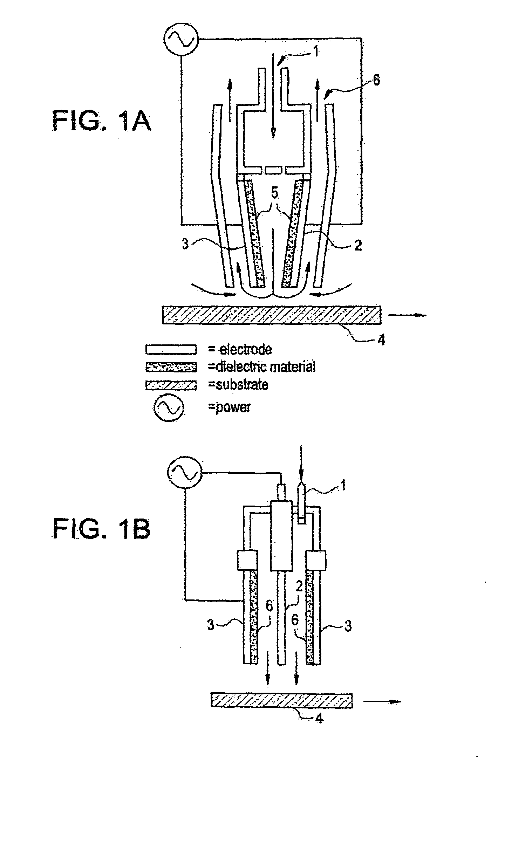

Figs. 1A and 1B show examples of nozzle arrangements that may be used to implement the principles of the invention. The nozzle arrangement of Fig. 1 A includes a linear slit-type nozzle designed to produce a plasma sheet, in which the vaporized reactants and carrier gases flow between two or more parallel, tilted, or curved plates arranged to optimize the laminar flow pattern, while the nozzle arrangement of Fig. 1 B includes a concentric cylindrical type nozzle, in which the discharge occurs in the annular region between a center needle electrode and the outer cylinder wall.

Each nozzle includes an inlet 1 in which reactants are introduced. The reactants are passed between two or more electrodes 2,3 to which is applied a voltage to create an electrical discharge. This discharge activates the reactants to facilitate deposition of the substrate 4. The remaining gas is then exhausted or recycled through an appropriate exhaust or recycling means such as outlet 6 shown in Fig. 1 A.

The electrodes preferably form or are incorporated into the nozzle to produce either a dielectric barrier discharge or a corona arc discharge. A dielectric barrier discharge can be created by applying an alternating high voltage to two electrodes typically separated by 1-20 mm. The voltage can either be supplied continuously or as a series of pulses. To accomplish the dielectric barrier discharge, at least one of the electrodes is covered with an insulating material 5 such as glass, alumina, or quartz to act as a dielectric barrier. Breakdown processes lead to short duration, localized discharges which contain ionized gas species and energetic electrons with energies of approximately 1-10 eV (roughly 100-1,000 kJ/mol). In the resulting nonequilibrium state, the effective electron temperature can be well over 10,000°C while the bulk gas temperature remains relatively low.

Those skilled in the art will appreciate that the invention is not limited to the nozzle arrangements disclosed in Figs. 1 A and 1 B, and that any of a variety of known nozzle configurations, and/or configurations of the apparatus is in which the nozzle is situated. For example, the slot-type nozzle of Fig. 1 may include two or more rod electrodes, or a combination of rods and plates, with appropriate ones (or all) of the plates or rods being covered by a dielectric material. Alternately, in case a cylindrical geometry is used, one or both of the electrodes may be covered with a dielectric material. In addition, the electrode surfaces or edges in each of the illustrated variations can include specifically designed projections to control the distribution of discharges.

In all of the above apparatus configurations, vaporized reactants and carrier gases are directed through the discharge. The reactant gases, including ionized and dissociated species created by the electrical discharge, impinge upon the substrate and react to deposit the coating at atmospheric pressure. Reaction products and unreacted gases can then be removed through outer exhaust slots of various configurations. To increase usage efficiency of the reactants, a portion of the exhaust gas can be recycled to the feed stream. When precious metals such as platinum are being deposited, metals or metal-containing reactants can also be recovered from the waste exhaust stream to maximize cost effectiveness.

An advantage of the DECVD technique used in the preferred embodiments of the invention is that the nozzle design can easily be expanded to coat arbitrarily wide substrates. For example, an array (not shown) of the above-described cylindrical nozzles can be used to create a large area for substrate treatment, the nozzles can be arranged to scan the substrate, or the substrate can be arranged to be advanced underneath a stationary nozzle. The method does not require vacuum chambers or vacuum pumps, which are expensive and/or difficult to scale up for coating large substrates. The exhaust system only requires standard blowers, so the entire process occurs essentially at atmospheric pressure. Another advantage is that the equipment can be mounted above the substrate, and no part need be in direct contact with the substrate. The substrate does not need to be fed into a coating chamber that surrounds the substrate on top and bottom, which is sometimes disadvantageous in certain processes.

In order to manufacture an MEA according to the principles of the invention, using an apparatus of the type schematically illustrated in Fig. 1 and/or any of the variations described above, the substrate is placed in the reaction chamber adjacent to the nozzle (step 10), a voltage is applied to the electrodes, and reactants are passed between the electrodes to enable deposition of metals from the precursor reactants onto the substrate (step 20). The MEA may then be completed by adding electrodes (step 30), for example by hot pressing carbon cloth on the already-formed active catalyst layer of the membrane.

To deposit metals, an appropriate volatile organometallic or inorganic precursor containing the desired metal element is selected. For example, precursors such as Pt(CO)₂Cl₂, Pt(acac)₂, or Pt(hfac)₂ could be used to deposit Pt-containing materials. The carrier gas is chosen to provide an inert or reducing environment such as N₂, NH₃, H₂, etc. Alternatively, however, a metal compound may be deposited (*e.g.*, nitride, carbide, oxide, *etc.*) under a different carrier gas, then reduced in a second treatment with a reducing carrier gas.

Unlike what is taught in the prior art, the use of a noble gas in the carrier gas to suppress arcing is not necessary. Microarcing does not impede creation of reactive species, and does not necessarily affect deposition uniformity if there is adequate randomization of microarc location and/or downstream gas mixing.

As discussed above, the invention permits a wide variety of polymer membranes to be utilized, as well as membranes formed of carbon cloth or carbon particles. For example, the membrane can be formed from perfluorosulfonic acids such as Nafion® and Aciplex®, polyethylene and polypropylene sulfonic acid, polystyrene sulfonic acid, and other polyhydrocarbon-based sulfonic acids, as well as polymer composites or blends. An especially preferred membrane material is an acrylic based polyelectrolyte/fluoropolymer blend described in WO 01/60872.

The invention also permits different types of catalysts to be deposited on the membrane. The catalysts may include not only pure platinum, but also binary and ternary platinum alloys containing metals from columns 4-11 of the periodic table. The catalysts can also take the form of a layered structure with various metals including, but are not limited to, metals from columns 4-11 of the periodic table.

[0032] Having thus described a preferred embodiment of the invention in sufficient detail to enable those skilled in the art to make and use the invention, it will nevertheless be appreciated that numerous variations and modifications of the illustrated embodiment may be made without departing from the invention, and it is intended that the invention not be limited by the above description or accompanying drawings, but that it be defined solely in accordance with the appended claims.

### Examples

### Example 1

15 grams of (CH₃C₅H₄)Pt(CH₃)₃ is placed in a stainless steel bubbler under dry nitrogen and heated to 50°C, where the (CH₃C₅H₄)Pt(CH₃)₃ is a volatile liquid. A carrier gas composed of 96% N₂ and 4% H₂ is bubbled through the (CH₃C₅H₄)Pt(CH₃)₄. The gas stream containing (CH₃C₅H₄)Pt(CH₃)₃ vapor is carried through stainless steel lines which are heated to maintain the temperature at 50°C to the DECVD reactor.

The vapor stream enters the DECVD equipment through a distributor plate, then passes through an array of nozzles in which the atmospheric pressure plasma discharge is initiated. Each nozzle consists of a metal electrode pin covered by alumina ceramic centered within a 1 cm diameter metal cylinder covered with an alumina ceramic insert. The center pins are connected in parallel to the main electrode of a high voltage, high frequency power supply, and the outer cylinders are connected in parallel to the ground electrode. The power supply applies a voltage of 10 kV at frequencies up to 20 kHz. This generates a dielectric discharge at atmospheric pressure in the annular region between the center pin and the outer cylinder. The vapor stream passes through this annular region and impinges on the proton conductive membrane located approximately 1-5 mm below the nozzles. The outer region of the proton conductive membrane is framed with gasket material (which is 70% thinner than the gas diffusion layer[GDL]) to the desired electrode active area. The membrane is at room temperature. The vapor is then exhausted from the outer region of the nozzle array. Under these conditions, we would expect Pt⁰ particles to be deposited on the proton conductive membrane at a loading of 0.01-0.1 mg/cm². The proton conductive membrane is turned over and the process is repeated to deposit Pt⁰ particles on the other side.

The GDLs are then mechanically applied to the framed Pt electrode area resulting in the final membrane electrode assembly (MEA). The MEA is then tested in a single cell fuel cell fixture in a temperature range of 60-80 °C. Hydrogen gas is used at the anode, with oxygen or air used at the cathode. The gases are fed at 100 % relative humidity with pressure ranging from atmospheric to 3 bar. Polarization curves and AC impedance measurements are taken under the various conditions.

### Example 2

The process of Example 1 is repeated, but one side of the proton conductive membrane is coated with both Pt⁰ and Mo⁰ particles on the side which will be used as the cathode. To deposit Mo⁰, Mo(CO)₆ is vaporized in a gas stream of 96% N₂ and 4% H₂. This stream is combined with the vapor stream containing (CH₃C₅H₄)Pt(CH₃)₃ and enters the DECVD equipment. The side of the proton conductive membrane which will be used as the anode is coated with only Pt⁰ as in Example 1.

### Example 3

The processes of Example 1 is repeated, but one side of the proton conductive membrane is coated with both Pt⁰ and Ru⁰ particles on the side which will be used as the anode. To deposit Ru⁰, Ru(C₅H₅)₂ is vaporized in a gas stream of 96% N₂ and 4% H₂. This stream is combined with the vapor stream containing (CH₃C₅H₄)Pt(CH₃)₃ and enters the DECVD equipment. The side of the proton conductive membrane which will be used as the cathode is coated with only Pt⁰ as in Example 1.

### Example 4

The process of Example 1, 2 and 3 is repeated, but the GDL is coated instead of the proton conductive membrane. The membrane is framed with the appropriate gasket with the desired electrode active area. The GDL is sized to the area and is mechanically pressed onto the membrane resulting in the final MEA.

## Claims

1. A method of manufacturing a proton-conducting cation-exchange electrolyte membrane for use in a membrane electrode assembly (MEA), comprising the step of depositing at least one catalyst layer directly onto a substrate by passing reactants included in a carrier gas through an electrical discharge at atmospheric pressure, wherein said substrate is selected from the group consisting of a polymer membrane, a membrane formed of carbon cloth, and a membrane including carbon particles, and wherein the deposition is carried out without adding a noble gas to the carrier gas.

2. A method according to claim 1, wherein at least a portion of the exhaust gas is recycled to the feed stream.

3. A method according to anyone of claims 1 to 2, wherein the reactants are passed through a nozzle containing parallel electrode plates for generating said discharge.

4. A method according to anyone of claims 1 to 2, wherein the reactants are passed through a nozzle containing coaxially-arranged electrodes for generating said discharge.

5. A method according to anyone of claims 1 to 4, wherein the reactants are passed through at least one nozzle for generating said discharge, and said nozzle is scanned over said membrane.

6. A method according to anyone of claims 1 to 4, wherein the reactants are passed through at least one nozzle for generating said discharge, and said membrane is advanced beneath said nozzle.

7. A method according to anyone of claims 1 to 6, wherein the substrate is a polymer electrolyte membrane (PEM).

8. A method according to claim 7, wherein the PEM is made of an acrylic based polyelectrolyte/fluoropolymer blend.

9. A method according to claim 7, wherein the PEM is made of a polyhydrocarbon-based sulfonic acid.

10. A method according to claim 7, wherein the PEM is made of Nafion® and Aciplex®.

11. A method according to anyone of claims 1 to 6, wherein the substrate includes carbon cloth.

12. A method according to anyone of claims 1 to 6, wherein the substrate includes carbon particles.

13. A method according to anyone of claims 1 to 12, wherein the catalyst layer includes a precious metal catalyst and preferably a platinum catalyst.

14. A method according to anyone of claims 1 to 12, wherein the catalyst layer includes a platinum alloy catalyst.

15. A method according to claim 14, wherein the catalyst is a platinum alloy that includes binary and ternary alloys using metals from columns 4-11 of the periodic table.

16. A method according to anyone of claims 1 to 15, wherein the step of depositing said at least one catalyst layer comprises the step of depositing multiple catalyst layers.

17. A method according to anyone of claims 1 to 16, wherein metals and/or metal-containing reactants are recovered from the waste exhaust stream.

## Patentansprüche

1. Verfahren zur Herstellung einer protonenleitenden Kationenaustausch-Elektrolytmembran zur Verwendung in einer Membranelektrodenanordnung (MEA), mit dem Schritt des Abscheidens wenigstens einer Katalysatorschicht direkt auf einem Substrat durch Leiten von Reaktionsteilnehmern, die in einem Trägergas enthalten sind, durch eine elektrische Entladung bei atmosphärischem Druck, wobei das Substrat aus einer Gruppe ausgewählt ist, die aus einer Polymermembran, einer aus Kohlenstoffgewebe bestehenden Membran und einer kohlenstoffpartikelhaltigen Membran besteht, und wobei das Abscheiden ohne die Beigabe eines Edelgases zu dem Trägergas erfolgt.

2. Verfahren nach Anspruch 1, wobei wenigstens ein Teil des Abgases in den Zustrom zurückgeführt wird.

3. Verfahren nach einem der Ansprüche 1 und 2, wobei die Reaktionsteilnehmer durch eine Düse geleitet werden, die parallele Elektrodenplatten zum Erzeugen der Entladung enthält.

4. Verfahren nach einem der Ansprüche 1 und 2, wobei die Reaktionsteilnehmer durch eine Düse geleitet werden, die koaxial angeordnete Elektroden zum Erzeugen der Entladung enthält.

5. Verfahren nach einem der Ansprüche 1 bis 4, wobei die Reaktionsteilnehmer durch wenigstens eine Düse zum Erzeugen der Entladung geleitet werden und die Düse über der Membran bewegt wird.

6. Verfahren nach einem der Ansprüche 1 bis 4, wobei die Reaktionsteilnehmer durch wenigstens eine Düse zum Erzeugen der Entladung geleitet werden und die Membran unter der Düse vorangeschoben wird.

7. Verfahren nach einem der Ansprüche 1 bis 6, wobei das Substrat eine Polymerelektrolytmembran (PEM) ist.

8. Verfahren nach Anspruch 7, wobei die PEM aus einer Polyelektrolyt-Fluorpolymer-Mischung auf Acryl basis hergestellt ist.

9. Verfahren nach Anspruch 7, wobei die PEM aus einer Sulfonsäure auf der Basis von polymerem Kohlenwasserstoff hergestellt ist.

10. Verfahren nach Anspruch 7, wobei die PEM aus Nafion® und Aciplex® hergestellt ist.

11. Verfahren nach einem der Ansprüche 1 bis 6, wobei das Substrat Kohlenstoffgewebe enthält.

12. Verfahren nach einem der Ansprüche 1 bis 6, wobei das Substrat Kohlenstoffpartikel enthält.

13. Verfahren nach einem der Ansprüche 1 bis 12, wobei die Katalysatorschicht einen Edelmetallkatalysator und vorzugsweise einen Platinkatalysator enthält.

14. Verfahren nach einem der Ansprüche 1 bis 12, wobei die Katalysatorschicht einen Platinlegierungs katalysator enthält.

15. Verfahren nach Anspruch 14, wobei der Katalysator eine Platinlegierung ist, die binäre und ternäre Legierungen unter Verwendung von Metallen aus den Spalten 4-11 des Periodensystems enthält.

16. Verfahren nach einem der Ansprüche 1 bis 15, wobei der Schritt des Abscheidens der wenigstens einen Katalysatorschicht den Schritt des Abscheidens mehrerer Katalysatorschichten aufweist.

17. Verfahren nach einem der Ansprüche 1 bis 16, wobei Metalle und/oder metallhaltige Reaktionsteilnehmer aus dem Abgasstrom zurückgewonnen werden.

## Revendications

1. Procédé de fabrication d'une membrane conductrice de protons et à échange de cations pour électrolyte destinée à être utilisée dans un ensemble membrane-électrode (MEA), qui comprend l'étape qui consiste à déposer au moins une couche de catalyseur directement sur un support en faisant passer à pression atmosphérique les réactifs contenus dans un gaz porteur à travers une décharge électrique, ledit support étant sélectionné dans l'ensemble constitué d'une membrane polymère, d'une membrane formée de tissu de carbone et d'une membrane qui contient des particules de carbone, le dépôt étant réalisé sans ajouter de gaz rare au gaz porteur.

2. Procédé selon la revendication 1, dans lequel au moins une partie des gaz épuisés est recyclée dans l'écoulement d'alimentation.

3. Procédé selon l'une quelconque des revendications 1 à 2, dans lequel les réactifs traversent un ajutage qui contient des plaques parallèles d'électrode pour créer ladite décharge.

4. Procédé selon l'une quelconque des revendications 1 à 2, dans lequel les réactifs traversent un ajutage qui contient des électrodes agencées coaxialement pour créer ladite décharge.

5. Procédé selon l'une quelconque des revendications 1 à 4, dans lequel les réactifs traversent au moins un ajutage pour créer ladite décharge, ledit ajutage étant déplacé au-dessus de ladite membrane.

6. Procédé selon l'une quelconque des revendications 1 à 4, dans lequel les réactifs traversent au moins un ajutage pour créer ladite décharge, ladite membrane étant agencée en dessous dudit ajutage.

7. Procédé selon l'une quelconque des revendications 1 à 6, dans lequel le support est une membrane polymère pour électrolyte (PEM).

8. Procédé selon la revendication 7, dans lequel la PEM est réalisée d'un mélange de polyélectrolyte à base acrylique et de polymère fluoré.

9. Procédé selon la revendication 7, dans lequel la PEM est réalisée en poly(acide sulfonique à base d'hydrocarbure).

10. Procédé selon la revendication 7, dans lequel la PEM est réalisée en Nafion® ou en Aciplex® .

11. Procédé selon l'une quelconque des revendications 1 à 6, dans lequel le support contient un tissu de carbone.

12. Procédé selon l'une quelconque des revendications 1 à 6, dans lequel le support contient des particules de carbone.

13. Procédé selon l'une quelconque des revendications 1 à 12, dans lequel la couche de catalyseur contient un catalyseur à métal précieux et de préférence un catalyseur au platine.

14. Procédé selon l'une quelconque des revendications 1 à 12, dans lequel la couche de catalyseur contient un catalyseur à alliage de platine.

15. Procédé selon la revendication 14, dans lequel le catalyseur est un alliage au platine qui contient des alliages binaires et ternaires obtenus en recourant à des métaux des colonnes 4 à 11 du tableau périodique.

16. Procédé selon l'une quelconque des revendications 1 à 15, dans lequel l'étape de dépôt de ladite au moins une couche de catalyseur comporte l'étape qui consiste à déposer plusieurs couches de catalyseur.

17. Procédé selon l'une quelconque des revendications 1 à 16, dans lequel les métaux et/ou les réactifs contenant des métaux sont recouverts par l'écoulement épuisé de déchet.
